# FASCICULE DE BREVET EUROPEEN

(11) **EP 0 621 489 B1**
(45) Date de publication et mention de la délivrance du brevet: **03.11.1999**
(21) Numéro de dépôt: 94410017.1
(22) Date de dépôt: 23.03.1994
(51) Int. Cl.: G01R 31/12, H02H 1/00, H02B 13/065

(54) **Dispositif de détection des décharges partielles pour l'appareillage électrique à haute tension**
Teilentladungsdetektionseinrichtung für elektrische Hochspannungsanlage
Partial discharge detecting device for electric high voltage appliance

(30) Priorité: 24.03.1993 JP 6509293
(43) Date de publication de la demande: 26.10.1994
(73) Titulaire: Schneider Electric High Voltage SA, 38050 Grenoble Cédex (FR); NISSIN ELECTRIC COMPANY, LIMITED, Ukyo-ku Kyoto-shi Kyoto (JP)
(72) Inventeur: Konma, Naohiro, Ukyo-Ku, Kyoto (JP); Saito, Kazutoshi, Ukyo-Ku, Kyoto (JP)
(74) Mandataire: Ritzenthaler, Jacques

(56) Documents cités:
- EP-A- 0 424 598
- EP-A- 0 488 719
- FR-A- 2 455 745
- US-A- 4 446 420
- US-A- 5 075 629
- PATENT ABSTRACTS OF JAPAN vol. 16, no. 45 (E-1162) 5 Février 1992 & JP-A-03 250 711 (TOSHIBA) 8 Novembre 1991
- PATENT ABSTRACTS OF JAPAN vol. 16, no. 150 (E-1189) 14 Avril 1992 & JP-A-04 004 708 (NISSIN ELECTRIC) 9 Janvier 1992
- PATENT ABSTRACTS OF JAPAN vol. 15, no. 401 (E-1121) 11 Octobre 1991 & JP-A-03 164 023 (NISSIN ELECTRIC)
- PATENT ABSTRACTS OF JAPAN vol. 16, no. 45 (E-1162) 5 Février 1992 & JP-A-03 250 710 (TOSHIBA)

## Description

Cette invention s'applique à l'industrie de l'appareillage électrique, notamment celle utilisée dans les postes blindés à haute tension isolés par un gaz diélectrique.

Les défaillances d'isolation à l'intérieur des postes blindés à haute tension se traduisent par des phénomènes de décharges partielles. Celles-ci apparaissent avant l'amorçage complet entre le conducteur haute tension et son enceinte métallique à bas potentiel. Un système de détection de ces décharges partielles permet donc de connaître les points faibles de l'isolation et d'y remédier avant le défaut.

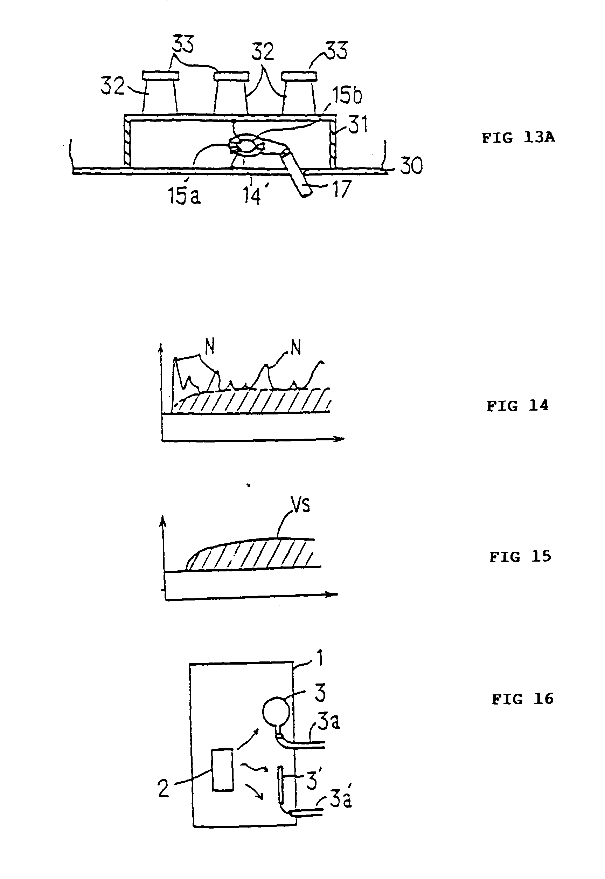

Il est connu de faire usage d'une antenne en forme de boucle pour la détection des ondes électromagnétiques hautes fréquences générées par les décharges partielles à l'intérieur de l'enceinte. La figure 16 montre un système d'antennes 3, 3' en forme de boucle traversant la cuve métallique 1 à travers un dispositif d'étanchéité et connecté par des câbles 3a et 3a' à un circuit de détection (non représenté).

Dans cette figure 16, l'existence d'une particule métallique au point 2 peut engendrer des décharges partielles. L'onde électromagnétique issue de ces décharges partielles est captée par les antennes 3 et 3'. Le circuit de détection amplifie le signal reçu et permet de détecter les décharges partielles.

La méthode de la figure 16 capte directement l'onde électromagnétique très faible issue des décharges partielles. La discrimination de ces décharges partielles hors du bruit de fond s'avère néanmoins difficile à cause du faible niveau signal/bruit. La sensibilité de la mesure peut encore décroître en cas de transmission des signaux et en cas de problèmes d'adaptation des impédances de l'antenne et du câble.

Pour résoudre ce problème, on peut utiliser un adaptateur d'impédance avec une impédance d'entrée limitée, mais le réglage des impédances d'antenne reste une opération difficile.

Le document US 4446420 décrit un dispositif de détection des décharges partielles dans un poste blindé isolé au gaz SF6, ayant un conducteur à haute tension s'étendant dans une enveloppe métallique. Le dispositif de détection utilise une bobine de Rogowski en forme de tore, logée dans une cavité annulaire de l'enveloppe, de manière à entourer concentriquement le conducteur à haute tension. La bobine délivre un signal de tension proportionnelle à la dérivée du courant circulant dans le conducteur à haute tension. La cavité de logement de la bobine est raccordée à une fente annulaire ayant deux parois suffisamment décalées axialement l'une de l'autre pour constituer un intervalle d'air. La fente procure exclusivement un effet d'isolement électrique pour la bobine de Rogowski.

Un premier objet de l'invention consiste à améliorer la sensibilité d'un dispositif de détection des décharges partielles dans un poste blindé à haute tension.

Un deuxième objet de l'invention consiste à réaliser un dispositif de détection des décharges partielles ayant une bonne compatibilité des impédances d'antenne et de câble.

Le dispositif selon l'invention est caractérisé en ce que les moyens de réception comportent une fente formée par un trou oblong dans la paroi de l'enveloppe métallique à potentiel bas, et une antenne réceptrice bobinée disposée à l'intérieur de ladite fente, laquelle est agencée pour constituer un circuit de résonance délivrant un courant de haute fréquence, avec formation d'un champ magnétique orienté suivant la grande longueur de la fente.

L'onde électromagnétique issue de la décharge partielle se propage dans le milieu gazeux avec une certaine impédance d'onde, et sur les parties conductrices touchant ce milieu sont générés des courants à hautes fréquences. La présence de la fente dans la partie à bas potentiel forme un circuit de résonance délivrant un courant de hautes fréquences. La détection de ce courant permet de détecter l'onde électromagnétique issue de la décharge partielle, avec une haute sensibilité grâce à l'antenne bobinée autorisant le réglage de l'impédance par modification du nombre de tours du bobinage. Il en résulte un ajustage aisé de l'impédance entre l'antenne et le câble.

Selon une caractéristique de l'invention, l'antenne bobinée est composée par un bobinage primaire et un bobinage secondaire. Les deux extrémités du bobinage primaire sont connectées de part et d'autre de la fente, approximativement au milieu de sa plus grande dimension. Cette bobine peut être enroulée autour d'un corps magnétique à haute fréquence, par exemple un matériau à base de ferrite.

Le réglage de l'impédance de sortie sur le câble s'effectue sans l'ajout d'un transformateur extérieur. L'adaptation de l'impédance de l'antenne s'opère avantageusement en jouant sur le nombre de tours des bobines de l'antenne. La sensibilité est améliorée par l'usage d'un noyau magnétique à hautes fréquences.

Selon une autre caractéristique de l'invention, un circuit bouchon à hautes fréquence, situe côté conducteur haute tension possède une haute impédance à fréquences élevées, et génère une différence de potentiel. Celle-ci excite un émetteur qui génère une onde électromagnétique à hautes fréquences. Cette onde est recueillie par la fente réceptrice située côté cuve, laquelle se trouve à un potentiel bas. Il en résulte un meilleur rapport signal/bruit avec une haute sensibilité de détection.

Selon un développement de l'invention, l'émetteur à hautes fréquences est formé par une fente sur le conducteur à haute tension. Deux points, situés à proximité du milieu de la fente et de part et d'autre de la fente, sont connectés aux deux extrémités du circuit bouchon à hautes fréquences.

L'émetteur peut également comporter un bobinage agencé autour d'un noyau magnétique. Ce dernier bobinage peut être disposé à proximité de la fente.

D'autres avantages et caractéristiques ressortiront plus clairement de la description qui va suivre de différents modes de réalisation de l'invention, donnés à titre d'exemples non limitatifs, et représentés aux dessins annexés, dans lesquels :
- La figure 1A est une vue partielle en coupe du poste blindé, équipé du dispositif de détection selon l'invention ;
- la figure 1B est une vue partielle de dessous de la figure 1A;
- la figure 2 est une vue schématique d'une fente ;
- la figure 3 est une vue identique de la figure 1B d'une variante de réalisation ;
- les figures 4 et 5A représentent d'autres variantes ;
- la figure 5B est une vue de profil de la figure 5A;
- la figure 6 montre une vue partielle en coupe d'une autre variante ;
- la figure 7 est une vue en coupe transversale de la figure 6 ;
- les figures 8 et 9 sont des vues en perspective partiellement arrachées de deux autres exemples de l'invention ;
- les figures 10 et 11 montrent des vues en coupe de deux autres exemples ;
- la figure 12A est une vue partielle en coupe d'un poste triphasé avec une autre variante de réalisation du dispositif de détection ;
- la figure 12B est une vue en perspective de la figure 12A;
- les figures 13 et 13A montrent des vues identiques de la figure 12A de deux autres variantes de réalisation ;
- les figures 14 et 15 représentent les diagrammes de la tension de sortie en fonction de la fréquence, respectivement en cas de non adaptation des impédances, et en cas de bonne compatibilité des impédances ;
- la figure 16 montre un dispositif de détection de l'art antérieur.

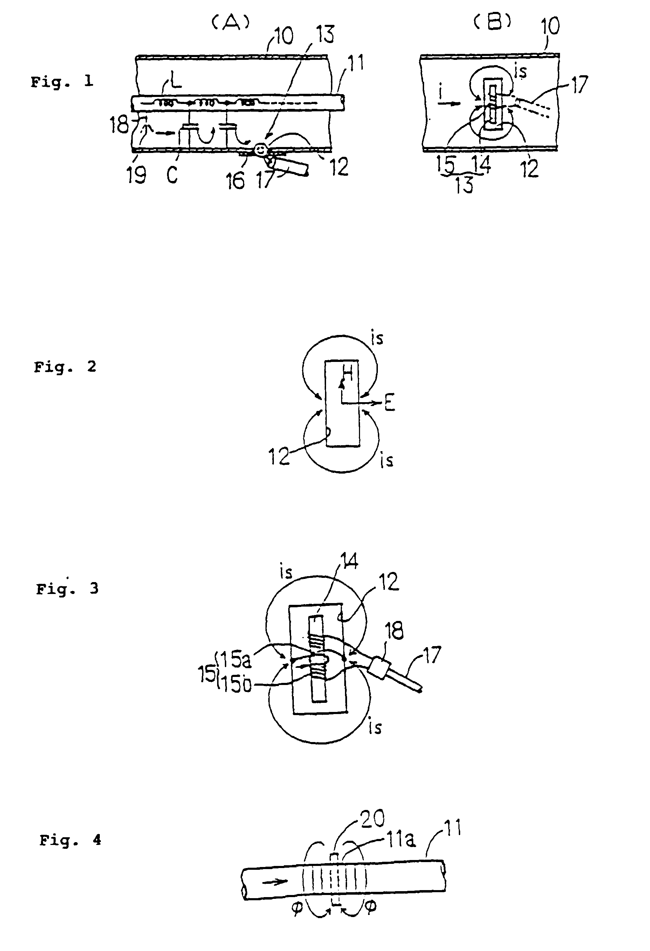

Les figures 1 (A) et (B) montrent un tronçon de poste blindé à haute tension ayant une cuve ou enveloppe 10 métallique constituant un conducteur à potentiel bas, et un conducteur 11 à haute tension agencé coaxialement à l'intérieur de la cuve 10. Un trou oblong est agencé dans l'épaisseur de la paroi de la cuve 10 pour former une fente 12, dans laquelle est disposée une antenne 13. L'antenne 13 est composée d'un noyau magnétique de ferrite 14 à hautes fréquences, et d'un bobinage ou bobine 15 entourant le noyau magnétique. L'axe principal du noyau magnétique est orienté dans la direction de l'axe principal de la fente 12. L'antenne 13 est montée sur un couvercle isolant 16 installé à l'extérieur de la cuve 10. Un câble 17 est relié aux extrémités de la bobine 15 et sort vers l'extérieur en passant à travers le couvercle 16. La cuve 10 est remplie par un gaz isolant, notamment du SF6.

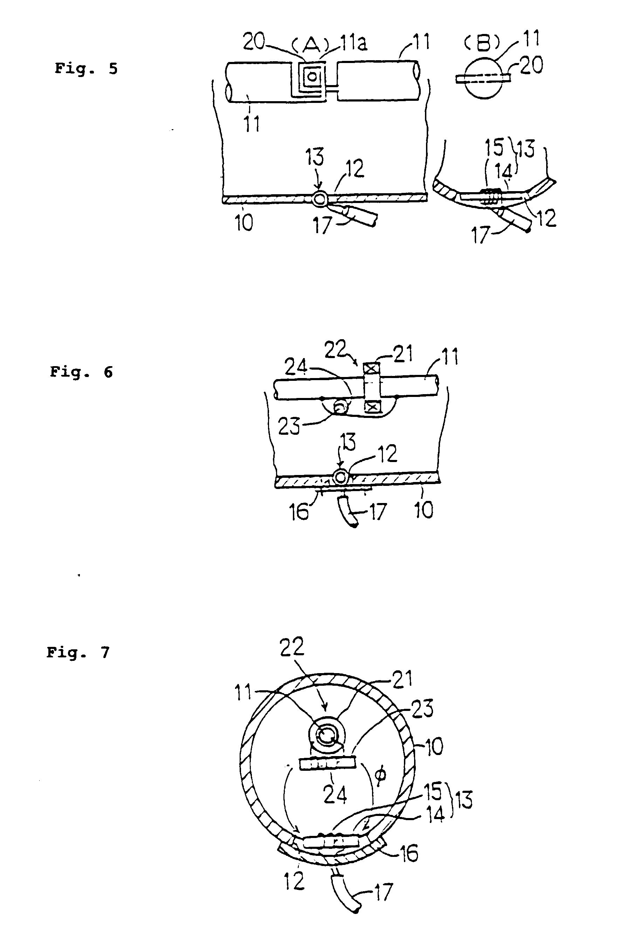

Dans la figure 1 (A), l'existence d'une particule conductrice 18, par exemple une limaille métallique attachée au conducteur 11, peut entraîner des décharges partielles 19 entre le conducteur 11 et la cuve 10. L'onde électromagnétique générée par ces décharges partielles se propage à l'intérieur de la cuve 10, cette propagation pouvant être modélisée par un circuit distribué formé d'inductances L et de capacités C. L'onde électromagnétique circule sur ce circuit avec une certaine impédance d'onde. Des courants à hautes fréquences circulent donc dans le conducteur 11 et la cuve 10. Le courant à hautes fréquences i circulant dans la cuve 10, entre en résonance à l'endroit de la fente, et provoque des courants secondaires de résonance is autour de la fente 12. Ces courants résonnants génèrent un champ électrique E et un champ magnétique H comme l'indique la figure 2. Le champ magnétique H est donc orienté suivant la grande longueur de la fente 12. Par la présence de l'antenne 13 dans la fente 12, le flux magnétique généré par le champ H passe dans le noyau 14 et induit aux bornes du bobinage 15 une tension Vs proportionnelle aux courants is. La détection de cette tension Vs sur le câble 17 permet d'obtenir l'image des décharges partielles à l'intérieur du poste.

En cas de mauvaise adaptation d'impédance entre l'antenne 13 et le câble 17, un bruit externe peut pénétrer par la jonction entre l'antenne 13 et le câble 17, en créant une composante en fréquence de bruit N sur les signaux utiles, ce qui détériore le rapport signal/bruit. Pour éviter la pénétration de ce type de bruit N, il est nécessaire d'ajuster l'impédance entre l'antenne 13 et le câble 17. Selon l'invention, l'ajustage du nombre de tours de la bobine 15 modifie l'impédance Zc de l'antenne 13, vue par le câble 17, et permet de régler Zc sur l'impédance caractéristique du câble. L'ajustage ne nécessite aucun adaptateur auxiliaire. Le signal Vs représentant les décharges partielles après l'ajustage est représenté sur la figure 20.

L'antenne 13 selon la figure 1 est reliée directement au câble de mesure 17. Selon une variante, un adaptateur d'impédance du commerce avec une impédance fixe prédéterminée peut être inséré pour ajuster le nombre de tours de l'antenne 13 de manière à ramener cette impédance à la valeur qui permet d'éviter la réception de bruit externe.

Le noyau de ferrite 14 n'est pas indispensable, mais sa présence augmente le nombre de lignes de flux traversant la bobine 15, ce qui permet d'augmenter la sensibilité.

La figure 3 montre un autre exemple de réalisation de la présente invention dans lequel la bobine 15 enroulée autour du noyau de ferrite 14 est composée d'une première bobine primaire 15a et d'une seconde bobine secondaire 15b. Les deux extrémités de la bobine primaire 15a sont branchées aux points milieux opposés de la fente 12 et les deux extrémités de la bobine secondaire 15b sont branchées au câble 17 au travers d'un transformateur adaptateur 18.

Dans ce cas le courant de résonance is passe directement dans la bobine primaire 15 a et excite ainsi le noyau 14. On obtient ainsi des signaux plus puissants que dans le cas de la figure 1.

Dans le cas de la figure 3, la bobine secondaire 15b est connectée au câble 17 par l'intermédiaire d'un transformateur adaptateur 18. Cependant les bobines d'antenne 15 agissent comme un transformateur; on peut donc éliminer le transformateur adaptateur 18 en ajustant de façon adéquate les nombres de tours ns et nf des bobines primaire 15a et secondaire 15b respectivement.

Les figures 4 et 5 montrent d'autres exemples de réalisation qui utilisent une bobine 11a formée de n tours (n> = 1) insérée directement sur le conducteur 11 à haute tension. Cette bobine 11a possède un noyau en ferrite 20 encastré dans le conducteur 11. Sur la cuve 10 à l'opposé de la bobine 11a, se trouve une fente 12 dont l'orientation est parallèle avec l'axe du noyau 20. Une antenne 13 équipée du bobinage 15 est disposée dans cette fente 12. Un couvercle (non représenté) peut être prévu pour réaliser l'étanchéité au niveau de la fente 12, à l'extérieur de la cuve 10, l'antenne 13 étant montée sur ce couvercle.

Dans ces cas, les décharges partielles génèrent des flux magnétiques φ (fig. 4) par l'intermédiaire du courant à hautes fréquences parcourant le conducteur haute tension 11. Ces flux sont alors détectés par la bobine 15 à bas potentiel.

Les figures 6 et 7 montrent d'autres réalisations qui utilisent un noyau en ferrite 21 en forme de tore monté autour du conducteur 11 à haute tension, pour former un circuit bouchon à hautes fréquences 22. Au voisinage du conducteur 11 à haute tension et orienté quasiment perpendiculairement par rapport à lui, est placé un corps magnétique 23 en ferrite en forme de bâtonnet, sur lequel est enroulée une bobine d'émission 24 à hautes fréquences. La bobine 24 est reliée aux deux côtés du conducteur 11, situés de part et d'autre du tore en ferrite 21.

Sur la cuve 10, et à l'opposé de la bobine d'émission 24, se trouve une fente 12 dont l'orientation est parallèle avec l'axe du noyau 23. Une antenne 13 réceptrice avec son bobinage 15 est disposée dans cette fente 12. Un couvercle 16 est monté pour réaliser l'étanchéité au niveau de la fente 12, à l'extérieur de la cuve 10, l'antenne 13 étant fixée sur ce couvercle 16. Les deux extrémités de la bobine 15 sont reliées au câble 17.

Dans le cas des figures 6 et 7, l'anneau de ferrite 21 engendre des pertes à hautes fréquences importantes, dues à la circulation du courant à hautes fréquences dans l'impédance de valeur élevée du circuit bouchon 22.

Si un courant à hautes fréquences généré par les décharges partielles circule dans le conducteur 11 à haute tension, une différence de potentiel est créée de part et d'autre du circuit bouchon 22, et est donc appliquée à la bobine 24. Le flux magnétique créé par la bobine 24 passe dans le corps magnétique 23. Les flux de fuite ⌀ sortant des extrémités du corps 23 entrent dans le noyau ferrite 14, disposé du côté de la cuve 10 à bas potentiel, et induisent alors dans la bobine 15 une différence de potentiel à hautes fréquences qui peut être détectée par le câble 17. L'émetteur HF est donc formé par le corps magnétique 23 et la bobine 24.

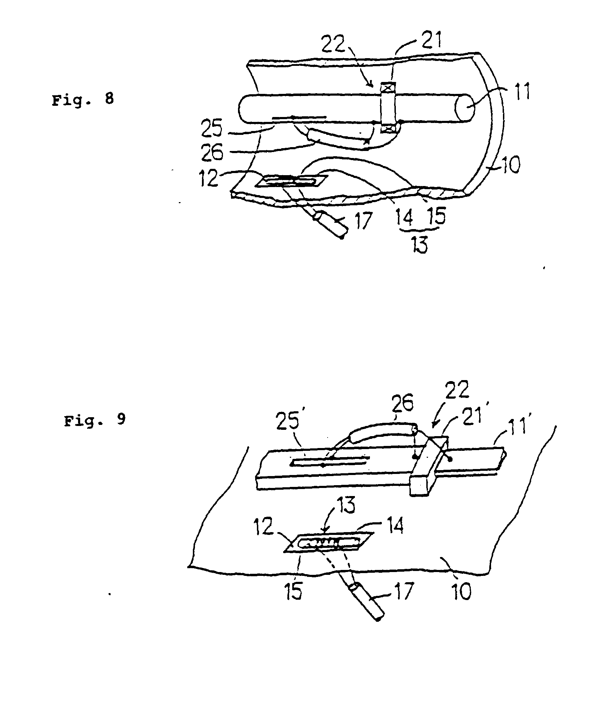

Dans le mode de réalisation de la figure 8, une fente 25 parallèle avec l'axe du conducteur 11 à haute tension se trouve au voisinage du circuit bouchon 22 à hautes fréquences. Un câble 26 relie les deux points milieux de la fente 25 et les deux côtés du conducteur 11 situés de part et d'autre du noyau 21. Sur la cuve 10, une fente 12 parallèle à la fente 25 est équipée d'une antenne 13, laquelle est identique à celles décrites dans les figures 1 à 7.

Dans le cas de la figure 8, la fente 25 forme l'émetteur HF qui est excité par la différence de potentiel aux bornes du circuit bouchon 22. L'onde électromagnétique est alors émise par la fente 25 vers la fente 12 et est captée par la bobine 15 de l'antenne 13.

Les réalisations présentées ci-dessus sont décrites avec des conducteurs en formes de barres ou de tubes de sections cylindriques. Mais l'invention est parfaitement applicable à un conducteur 11' de section carré ou rectangulaire comme indiqué sur la figure 9. La réalisation de la figure 9 est identique à celle de la figure 8 mise à part la section rectangulaire de conducteur 11' et du noyau 21' en ferrite.

Dans les figures 6 à 9, l'antenne 13 réceptrice montée du côté à bas potentiel, est composée de la fente 12, du noyau de ferrite 14 et de la bobine 15 enroulée autour du noyau 14.

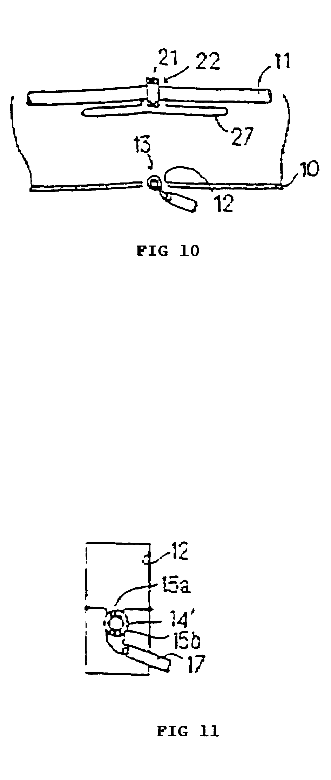

La figure 10 montre un autre de cas de réalisation en utilisant une antenne émettrice à boucle 27 reliée aux deux côtés du circuit bouchon 22. En cas de décharges partielles, une différence de potentiel est générée aux bornes du circuit bouchon 22, pour exciter l'antenne 27, laquelle provoque l'émission d'une onde électromagnétique vers l'antenne réceptrice 13.

Les réalisations ci-dessus ont montré des noyaux de ferrite en forme de barreau, mais rien n'empêche d'utiliser un noyau de ferrite en forme d'anneau, comme le montre la figure 11, dans laquelle le noyau 14' porte l'antenne bobinée primaire 15a et secondaire 15b.

Les exemples ci-dessus décrivent le cas d'utilisation d'un seul dispositif de détection des décharges partielles. Mais on peut segmenter l'appareillage en plusieurs zones distinctes de détection et monter les détecteurs dans chaque zone, puis comparer les valeurs détectées par les différents dispositifs pour permettre de localiser le siège des décharges partielles.

Les exemples ci-dessus décrivent un type de réalisation du circuit de résonance où la fente est découpée directement dans le conducteur. L'invention permet également l'usage de tout autre type de réalisation du circuit de résonance, notamment par combinaison de pièces formant une fente.

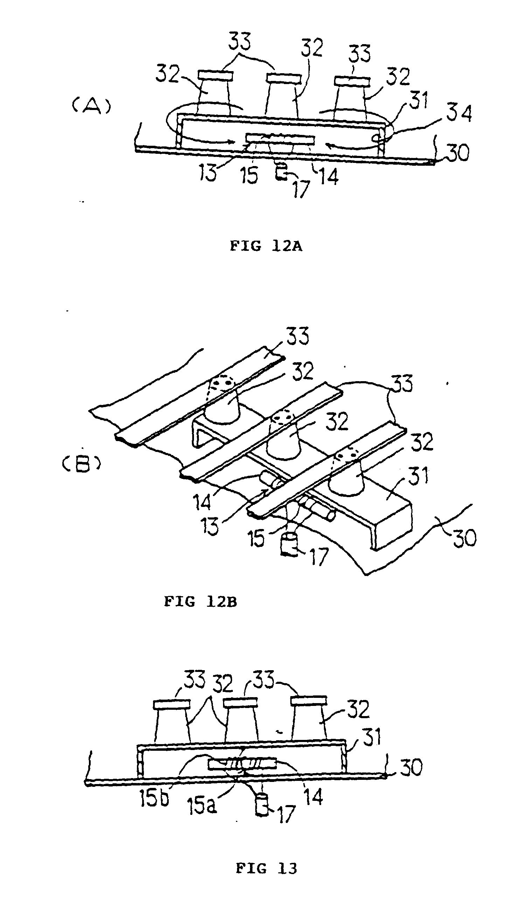

Par exemple, dans les figures 12 (A) et (B), le fond 30 d'une enceinte métallique porte une pièce support conductrice 31 sur laquelle sont fixés les conducteurs des trois phases 33 au moyen d'isolateurs support 32. La pièce support conductrice 31 est constituée par un pont, délimitant une ouverture 34 par rapport au fond 30. L'antenne réceptrice 13 est montée dans l'espace entre la pièce support 31 et le fond 30 pour détecter l'onde électromagnétique avec une bonne sensibilité. L'antenne 13 est composée d'une bobine 15 enroulée autour d'un noyau de ferrite 14, ou d'un tore 14' (figure 13A).

Dans ce cas, on peut également utiliser une antenne 15 composée d'un premier bobinage 15a et d'un second bobinage 15b, les embouts de 15a étant connectés au support 31 et au fond 30, afin d'accroître encore la sensibilité comme présenté dans la figure 13.

## Revendications

1. Dispositif de détection des décharges partielles dans un poste électrique blindé à haute tension logé dans une enveloppe (10) métallique étanche remplie d'un gaz diélectrique, ladite enveloppe (10) se trouvant à un potentiel bas et renfermant au moins un conducteur (11, 11', 33, 44) à haute tension, le dispositif de détection comportant :
- des moyens de réception des ondes électromagnétiques se propageant à l'intérieur de l'enveloppe (10) suite à l'apparition des décharges partielles dans le milieu gazeux,
- et un circuit de traitement des signaux délivrés par les moyens de réception, ledit circuit de traitement étant disposé à l'extérieur de l'enveloppe (10),
caractérisé en ce que les moyens de réception comportent une fente (12) formée par un trou oblong dans la paroi de l'enveloppe métallique (10) à potentiel bas, et une antenne (13) réceptrice bobinée disposée à l'intérieur de ladite fente (12), laquelle est agencée pour constituer un circuit de résonance délivrant un courant de haute fréquence, avec formation d'un champ magnétique H orienté suivant la grande longueur de la fente (12).

2. Dispositif de détection des décharges partielles selon la revendication 1, caractérisé en ce que l'antenne (13) réceptrice comporte une bobine primaire (15a), et une bobine secondaire (15b), et que les extrémités de la bobine primaire (15a) sont connectées à des points milieux opposés de la fente (12).

3. Dispositif de détection des décharges partielles selon la revendication 1 ou 2, caractérisé en ce que l'antenne (13) réceptrice est bobinée autour d'un noyau (14) magnétique à haute fréquence, notamment un matériau à base de ferrite.

4. Dispositif de détection des décharges partielles selon l'une des revendications 1 à 3, caractérisé en ce qu'un circuit bouchon (22) à haute impédance est disposé sur le conducteur (11) à haute tension pour engendrer une différence de potentiel suite à l'apparition d'un rayonnement électromagnétique issu des décharges partielles, et qu'un moyen émetteur est excité par la différence de potentiel pour émettre un signal HF vers l'antenne (13) réceptrice.

5. Dispositif de détection des décharges partielles selon la revendication 4, caractérisé en ce que le moyen émetteur est formé par une fente (25, 25') agencée dans le conducteur (11, 11') à haute tension au voisinage du circuit bouchon (22), et en regard de la fente (12) de l'antenne (13) réceptrice.

6. Dispositif de détection des décharges partielles selon la revendication 4, caractérisé en ce que le moyen émetteur est composé d'un noyau (23) magnétique en ferrite, sur lequel est enroulée une bobine (24) d'émission, et que ladite bobine est connectée en deux points du conducteur (11) à haute tension situés de part et d'autre du circuit bouchon (22).

7. Dispositif de détection des décharges partielles selon la revendication 6, caractérisé en ce que la bobine (24) d'émission est située près du conducteur (11) à haute tension, et en regard de la fente (12) de l'antenne (13) réceptrice.

## Patentansprüche

1. Anordnung zur Erfassung von Teilentladungen in einer gekapselten elektrischen Hochspannungs-Schaltanlage mit einer gasdichten, mit einem Isoliergas gefüllten metallischen Umhüllung (10), welche Umhüllung (10) auf niedrigem Potential liegt und mindestens einen Hochspannungsleiter (11, 11', 33, 44) enthält, wobei die Erfassungsanordnung
- Mittel zum Empfang elektromagnetischer Wellen, die sich als Folge von Teilentladungen in der Gasatmosphäre im Innern der Umhüllung (10) ausbreiten,
- sowie eine Schaltung zur Verarbeitung der von den Empfangsmitteln gelieferten Signale umfaßt, welche Verarbeitungsschaltung außerhalb der Umhüllung (10) angeordnet ist,
dadurch gekennzeichnet, daß die Empfangsmittel einen, in der Wand der auf niedrigem Potential liegenden metallischen Umhüllung (10) als Langloch ausgebildeten Spalt (12) sowie eine im genannten Spalt (12) angeordnete, spulenförmige Empfangsantenne (13) umfassen, die als, einen hochfrequenten Strom liefernder Resonanzkreis ausgelegt ist, wobei ein parallel zur Längsseite des Spalts (12) gerichtetes magnetisches Feld (H) erzeugt wird.

2. Anordnung zur Erfassung von Teilentladungen nach Anspruch 1, dadurch gekennzeichnet, daß die Empfangsantenne (13) eine Primärwicklung (15a) und eine Sekundärwicklung (15b) umfaßt und daß die zwei Enden der Primärwicklung (15a) jeweils an einander gegenüberliegenden Mittelpunkten der Längsseiten des Spalts (12) angeschlossen sind.

3. Anordnung zur Erfassung von Teilentladungen nach Anspruch 1 oder 2, dadurch gekennzeichnet, daß die Empfangsantenne (13) um einen HF-Magnetkern (14), insbesondere ein Ferritmaterial gewickelt ist.

4. Anordnung zur Erfassung von Teilentladungen nach einem der Ansprüche 1 bis 3, dadurch gekennzeichnet, daß ein HF-Sperrkreis (22) mit hoher Impedanz am Hochspannungsleiter (11) angebracht ist, um als Folge einer durch die Teilentladungen verursachten elektromagnetischen Strahlung eine Potentialdifserenz zu erzeugen, und daß ein Sendeelement durch diese Potentialdifferenz erregt wird, um ein HF-Signal in Richtung der Empfangsantenne (13) auszusenden.

5. Anordnung zur Erfassung von Teilentladungen nach Anspruch 4, dadurch gekennzeichnet, daß das Sendeelement aus einem im Hochspannungsleiter (11, 11') in der Nähe des Sperrkreises (22) und gegenüber dem Spalt (12) der Empfangsantenne (13) ausgebildeten Spalt (25, 25') besteht.

6. Anordnung zur Erfassung von Teilentladungen nach Anspruch 4, dadurch gekennzeichnet, daß das Sendeelement aus einem, mit einer Sendespule (24) umwickelten Ferritmagnetkern (23) besteht, und daß die genannte Spule an zwei, auf beiden Seiten des Sperrkreises (22) liegende Punkte des Hochspannungsleiters (11) angeschlossen ist.

7. Anordnung zur Erfassung von Teilentladungen nach Anspruch 6, dadurch gekennzeichnet, daß die Sendespule (24) in der Nähe des Hochspannungsleiters (11) und gegenüber dem Spalt (12) der Empfangsantenne (13) angeordnet ist.

## Claims

1. A device for detection of partial discharges in a high-voltage metalclad electrical substation housed in a sealed metal enclosure (10) filled with a dielectric gas, said enclosure (10) being at a low potential and housing at least one high-voltage conductor (11, 11', 33, 44), the detection device comprising:
- receiver means for receiving the electromagnetic waves propagating inside the enclosure (10) following the occurrence of partial discharges in the gaseous environment,
- and a processing circuit of the signals delivered by the receiver means, said processing circuit being arranged outside the enclosure (10),
characterized in that the receiver means comprise a slot (12) formed by an oblong hole in the wall of the metal enclosure (10) at low potential, and a wound receiver antenna (13) arranged inside said slot (12), which is arranged to form a resonance circuit delivering a high-frequency current, with formation of a magnetic field H oriented according to the large length of the slot (12).

2. The device for detection of partial discharges according to claim 1, characterized in that the receiver antenna (13) comprises a primary coil (15a) and a secondary coil (15b), and that the ends of the primary coil (15a) are connected to opposite midpoints of the slot (12).

3. The device for detection of partial discharges according to claim 1 or 2, characterized in that the receiver antenna (13) is wound around a high-frequency magnetic core (14), in particular a ferrite-based material.

4. The device for detection of partial discharges according to one of the claims 1 to 3, characterized in that a high-impedance trap circuit (22) is arranged on the high-voltage conductor (11) to generate a potential difference following the occurrence of an electro-magnetic radiation arising from the partial discharges, and that a transmitter means is excited by the potential difference to transmit an HF signal to the receiver antenna (13).

5. The device for detection of partial discharges according to claim 4, characterized in that the transmitter means is formed by a slot (25, 25') arranged in the high-voltage conductor (11, 11') near to the trap circuit (22), and facing the slot (12) of the receiver antenna (13).

6. The device for detection of partial discharges according to claim 4, characterized in that the transmitter means is composed of a magnetic core (23) made of ferrite, on which an emission coil (24) is wound, and that said coil is connected at two points of the high-voltage conductor (11) situated on each side of the trap circuit (22).

7. The device for detection of partial discharges according to claim 6, characterized in that the emission coil (24) is situated close to the high-voltage conductor (11), and facing the slot (12) of the receiver antenna (13).
